# EUROPÄISCHE PATENTANMELDUNG

(11) **EP 0 893 697 A2**
(43) Veröffentlichungstag der Anmeldung: **27.01.1999**
(21) Anmeldenummer: 98111697.3
(22) Anmeldetag: 25.06.1998
(51) Int. Cl.: G01R 31/00, G01R 1/04

(54) **Diagnoseprüfgerät für elektronische Steuergeräte in unterschiedlichen Kraftfahrzeugtypen**

(30) Priorität: 21.07.1997 DE 19731283
(71) Anmelder: Bayerische Motoren Werke Aktiengesellschaft, 80788 München (DE); KONTRON ELEKTRONIK GMBH, D-85386 Eching (DE)
(72) Erfinder: Godau, Ralf, 82178 Puchheim (DE); Rowedder, Michael, 80993 München (DE)

(57) **Zusammenfassung**

Bei einem Diagnoseprüfgerät für elektronische Steuergeräte in unterschiedlichen Kraftfahrzeugtypen, das über eine Steckerverbindung an einen mit den zu diagnostizierenden Steuergeräten verbundenen Diagnosesteckeranschluß in jedem Kraftfahrzeug anschließbar ist, der mit einer vorgegebenen Anzahl von Steckkontakten mechanisch, nicht aber bezogen auf die Signalbelegung der Steckkontakte und auf die elektrischen Eigenschaften der zu übertragenden Signale normiert ist, ist die Steckerverbindung eine für die unterschiedlichen Kraftfahrzeugtypen identische Universalsteckerverbindung, die an den normierten Diagnosesteckeranschluß mechanisch angepaßt ist. Weiterhin ist am diagnosegerätseitigen Ende der Universalsteckerverbindung eine Adaptereinheit angeschlossen, die automatisch die erforderlichen elektrischen Verbindungen zwischen den Steckkontakten der Universalsteckerverbindung und der zentralen Rechnereinheit des Diagnosegeräts entsprechend der jedem Kraftfahrzeugtyp zuordneten Signalbelegung der Steckkontakte herstellt.

## Beschreibung

Die Erfindung betrifft ein Diagnoseprüfgerät für elektronische Steuergeräte in unterschiedlichen Kraftfahrzeugtypen nach dem Oberbegriff des Patentanspruchs 1.

Zum Anschluß eines Diagnoseprüfgeräts verfügen die heutigen Kraftfahrzeuge über einen fest eingebauten Diagnosesteckeranschluß, der kraftfahrzeugseitig mit den zu diagnostizierenden Steuergeräten verbunden ist. Aufgrund internationaler Vorschriften für die sog. On-Board-Diagnose-Systeme für Kraftfahrzeuge sind die Diagnosesteckeranschlüsse bei den verschiedenen Fahrzeugtypen mechanisch, insbesondere im Hinblick auf die vorgegebene Anzahl von Steckkontakten und im Hinblick auf die Form des Diagnosesteckeranschlusses, identisch. Bei vielen Kraftfahrzeugherstellern werden derzeit üblicherweise als Diagnosesteckeranschluß der 16polige OBD II-Stecker nach der SAE-Norm, SAE-J-1962, eingesetzt. Dieser Diagnosesteckeranschluß ist teilweise nicht normiert bezogen auf die Signalbelegung der Steckkontakte und auf die elektrischen Eigenschaften der zu übertragenden Signale. Beispielsweise können die elektrischen Fehlerdiagnose-Signale über die üblichen Diagnosebusleitungen bei den verschiedenen Fahrzeugtypen auf unterschiedliche Steckkontakte des Diagnosesteckeranschlusses gelegt sein. Darüber hinaus können die elektrischen Eigenschaften der zu übertragenden Signale, insbesondere aufgrund kraftfahrzeugseitig unterschiedlich defnierter Innenwiderstände, Eingangsschaltschwellen oder Ausgangspegel, von Fahrzeug zu Fahrzeug variieren. Dieses Problem wird bisher dadurch gelöst, daß zum Diagnoseprüfgerät eine Vielzahl von unterschiedlichen Adapterkabeln als Steckerverbindung zwischen Kraftfahrzeug und Diagnosegerät hinzugeliefert werden, die für die verschiedenen Fahrzeugtypen die jeweils erforderlichen elektrischen Verbindungen und Anpassungen auf die elektrischen Eigenschaften herstellen. Diese Lösung ist im Hinblick auf Kosten, Logistikaufwand und Fehlbedienungswahrscheinlichkeit durch Verwechseln der Adapterkabel besonders nachteilig.

Es ist daher Aufgabe der Erfindung, ein Diagnoseprüfgerät eingangs genannter Art derart zu verbessern, daß die vorgenannten Nachteile beseitigt werden.

Diese Aufgabe wird durch die kennzeichnenden Merkmale des Patentanspruchs 1 gelöst. Vorteilhafte Weiterbildungen der Erfindung sind die Gegenstände der Unteransprüche.

Durch das erfindungsgemäße Diagnoseprüfgerät wird die Vielzahl von Adapterkabel durch eine einzige Universalsteckerverbindung für alle Kraftfahrzeugtypen ersetzt. Die Funktion der Vielzahl von Adapterkabel wird durch eine einzige Adaptereinheit übernommen, die automatisch die erforderlichen elektrischen Verbindungen und Anpassungen an die elektrischen Eigenschaften der zu übertragenden Signale herstellt. Vorzugsweise weist hierzu die Adaptereinheit einen in seiner Funktion und/oder in seiner Pinbelegung umprogrammierbaren Baustein auf, der beispielsweise als sog. FPGA- (field programmable gate arrays) Baustein der Firma Xilinx bekannt ist. Da dieser Baustein grundsätzlich ungeeignet ist, Kraftfahrzeugsignale, insbesondere hohen Pegels, zu verarbeiten, arbeitet dieser Baustein mit Treibern in Form von universellen Sender- und/oder Empfänger-Einheiten zusammen. Vorzugsweise ist jedem Steckkontakt der Universalsteckerverbindung ein Treiber zugeordnet. Die Treiber können beispielsweise als Empfänger, als Sender oder als Sender und Empfänger für bidirektionale Signale arbeiten.

Die Arbeitsweise der Treiber ist mittels des umprogrammierbaren Bausteins konfigurierbar. Auch die Anpassung auf die elektrischen Eigenschaften der zu übertragenden Signale findet vorzugsweise durch entsprechende Konfigurierung der Treiber mittels des umprogrammierbaren Bausteins statt. Durch den in seiner Funktion und in seiner Pinbelegung umprogrammierbaren Baustein können beispielsweise in ihrem Informationsgehalt gleichartige Signale, die bestimmten Eingängen oder Ausgängen des Diagnoseprüfgeräts bzw. dessen zentralen Rechners zugeordnet sind, an diesen Ein- oder Ausgängen angelegt werden, auch wenn diese Signale über unterschiedliche Steckkontakte des Diagnosesteckeranschlusses und mit unterschiedlichen elektrischen Eigenschaften (z. B. Pegelunterschiede) übertragen werden.

Vorzugsweise erkennt die Adaptereinheit durch Anlegen bestimmter Eingangssignale welcher Kraftfahrzeugtyp momentan zu diagnostizieren ist und adaptiert daraufhin automatisch auf die entsprechende Signalbelegung der Steckkontakte und auf die elektrischen Eigenschaften der zu übertragenden Signale. Derartige Eingangssignale zur Erkennung eines bestimmten Kraftfahrzeugtyps können beispielsweise manuell, z. B. durch Betätigung eines Schalters am Diagnoseprüfgerät, erzeugt werden oder gleich einem über einen definierten Steckkontakt vom Kraftfahrzeug übermittelten Signal sein, das zur Unterscheidung der Kraftfahrzeugtypen geeignet ist.

Durch das erfindungsgemäße Diagnoseprüfgerät wird eine erhebliche Kostenreduzierung erreicht, da der zusätzliche Adapter zum Gesamtpreis des Diagnoseprüfgeräts nur unwesentlich beiträgt, wogegen die Vielzahl der Adapterkabel eingespart werden können. Darüber hinaus werden durch die Verwendung einer einzigen Universalsteckerverbindung und des teilweise vollautomatischen Adapters die Bedienung des Diagnoseprüfgeräts vereinfacht und Fehlbedienungsmöglichkeiten ausgeschlossen.

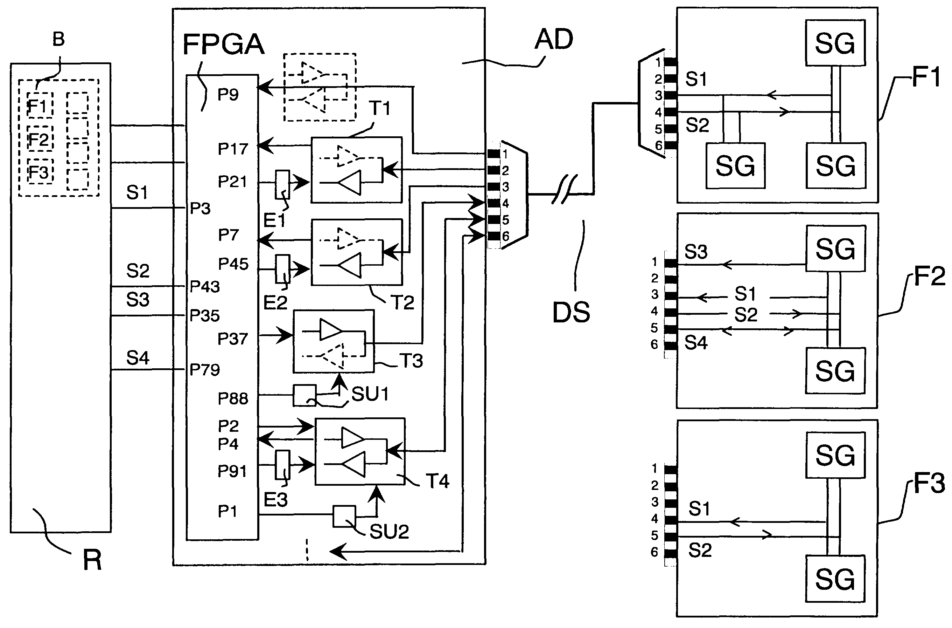

In der Zeichnung ist ein Ausführungsbeispiel der Erfindung dargestellt. Sie zeigt das Zusammenwirken unterschiedlicher Kraftfahrzeugtypen mit einer universellen Adaptereinheit eines erfindungsgemäßen Diagnoseprüfgeräts.

In der Zeichnung sind drei unterschiedliche Kraftfahrzeugtypen F1 bis F3 dargestellt, die sich auch bezüglich der Anordnung und der Anzahl von elektronischen Steuergeräten SG unterscheiden. Die elektronischen Steuergeräte SG sind beispielsweise über einen Datenbus miteinander verbunden. Einzelne Signale S1 bis S4, die Ein- und/oder Ausgangssignale eines bestimmten Steuergeräts SG sind, sind mit einem Diagnosesteckeranschluß verbunden, der Steckkontakte 1 bis 6 aufweist und für die Kraftfahrzeugtypen F1 bis F3 mechanisch identisch ist.

Die Signale S1 und S2 sind beispielsweise die elektrischen Signale über zwei Diagnoseleitungen, wie sie entsprechend der internationalen Vorschriften für die on-board-Diagnose definiert sind. Das Signal S3 ist beispielsweise die Batteriespannung als analoges Signal und das Signal S4 ist beispielsweise ein digitales bidirektionales Signal.

Das Diagnoseprüfgerät besteht aus einer zentralen Rechnereinheit R und einer Adaptereinheit AD. Den Signalen S1 und S3 ist jeweils ein Eingang an der zentralen Rechnereinheit R zugeordnet. Ebenso ist an der zentralen Rechnereinheit R dem bidirektionalen Signal S4 ein Ein-/Ausgang und dem Signal S2 ein Ausgang zugeordnet.

Beim Fahrzeugtyp F1 liegen die Signale S1 und S2 an den Steckkontakten 3 und 4 des Diagnosesteckeranschlusses an. Dieselben Signale S1 und S2 liegen dagegen beim Fahrzeugtyp F3 an den Steckkontakten 4 und 5 des Diagnosesteckeranschlusses an. Die Signale S3 und S4 des Fahrzeugtyps F2 liegen an den Steckkontakten 1 und 5 an. Insbesondere im Hinblick auf die Fahrzeugtypen F1 und F2 und im Hinblick auf die Signale S1 und S2 besteht das Problem, daß eine unterschiedliche Signalbelegung der Steckkontakte vorliegt. Aufgabe der Adaptereinheit ist es, die erforderlichen elektrischen Verbindungen zwischen den Steckkontakten 3 und 4 des Fahrzeugtyps F1 bzw. zwischen den Steckkontakten 4 und 5 des Fahrzeugtyps F3 und den den Signalen S1 und S2 zugeordneten Anschlüssen der zentralen Rechnereinheit R herzustellen. Als Steckverbindung zwischen den unterschiedlichen Kraftfahrzeugtypen F1 bis F3 und der Adaptereinheit AD des Diagnoseprüfgeräts wird eine einzige für alle Kraftfahrzeugtypen identischen Universalsteckerverbindung DS eingesetzt. Die Anzahl der kraftfahrzeugseitigen Steckkontakte 1 bis 6 sind gleich der Anzahl der adapterseitigen bzw. diagnoseprüfgerätseitigen Steckkontakte 1 bis 6. Die Steckkontakte 1 bis 6 sind 1:1 durchverbunden.

Die Adaptereinheit AD weist einen in seiner Funktion und in seiner Pinbelegung umprogrammierbaren Baustein FPGA sowie sechs Treiber, T1 bis T4 und zwei nicht bezeichnete Treiber, in Form von universellen Sender- und/oder Empfänger-Einheiten auf. Jedem Steckkontakt 1 bis 6 der Universalsteckerverbindung DS ist ein Treiber zugeordnet. Die Konfigurierung eines Treibers, z. B. als Sender-Einheit, als Empfänger-Einheit oder als Sender- und Empfängereinheit, wird durch den Baustein FPGA entsprechend der jeweils an den Steckkontaken 1 bis 6 anliegenden Signale in Abhängigkeit von dem montan vorliegenden Kraftfahrzeugtyp variierbar vorgenommen.

Beispielsweise wird das Signal S1 des Fahrzeugtyps F1 über den Steckkontakt 3 an den Treiber T2 der Adaptereinheit AD übermittelt. Ist der Kraftfahrzeugtyp F1 zu diagnostizieren, wird vom Baustein FPGA der Treiber T2 als Empfänger-Einheit konfiguriert. Das Signal S1 wird am Pin P7 des FPGA eingelesen und über den Pin P3 an die zentrale Rechnereinheit R ausgegeben. Wird beispielsweise bei Vorliegen des Kraftfahrzeugtyps F1 das Signal S2 von der zentralen Rechnereinheit R an den Pin P43 des Bausteins FPGA ausgegeben, leitet der Baustein FPGA über den Pin P37 und den Treiber T3, der für den Fahrzeugtyp F1 als Sender-Einheit konfiguriert ist, das Signal S2 an den Steckkontakt 4 der Universalsteckerverbindung DS weiter.

Das Signal S3 wird bei Vorliegen des Kraftfahrzeugtyps F2 über den Steckkontakt 1 an die Adaptereinheit AD weitergegeben. Da das Signal S3 eine analoge Batteriespannung ist, wird der dem Steckkontakt 1 zugeordnete Treiber ausgeschaltet bzw. umgangen, da ein Treiber nur zur Umsetzung digitaler Signale benötigt wird. Der dem Steckkontakt 1 zugeordnete Treiber ist demnach für den Fahrzeugtyp F2 derart konfiguriert, daß er lediglich als weiterführende Leitung des Signals S3 an den Pin P9 des Bausteins FPGA funktioniert. Das Signal S3 wird von dem Baustein FPGA über den PIN P35 an die zentrale Rechnereinheit R weitergeleitet.

Das am Steckkontakt 5 anliegende bidirektionale Signal S4 bei Vorliegen des Fahrzeugtyps F2 wird mittels des Treibers T4 der Adaptereinheit AD bearbeitet. Ist also der Fahrzeugtyp F2 zu diagnostizieren, wird der Treiber T4 vom Baustein FPGA als Sender- und Empfänger-Einheit konfiguriert. Der Teil des Signals S4, der vom Diagnosegerät zum Fahrzeug übertragen werden soll, wird vom zentralen Rechner R über den Pin P79 und den Pin P2 über den Treiber T4 an den Steckkontakt 5 der Universalsteckerverbindung DS übermittelt. Der Teil des Signals S4, der vom Fahrzeug zum Diagnosegerät gesendet werden soll, wird ebenfalls über den Treiber T4 sowie über die Pins P4 und P79 des Bausteins FPGA an die zentrale Rechnereinheit R gesendet.

Ist beispielsweise der Fahrzeugtyp F3 zu diagnostizieren, ist im Unterschied zum Fahrzeugtyp F1 und zum Fahrzeugtyp F2 das Signal S1 über den Steckkontakt 4 vom Fahrzeug zum Diagnosegerät zu übertragen. Wird der Adaptereinheit AD das Vorliegen des Fahrzeugtyps F3 mitgeteilt, wird der dem Steckkontakt 4 zugeordnete Treiber T3, der in der Zeichnung als Sender-Einheit dargestellt ist, als Empfänger-Einheit umkonfiguriert. Ebenso wird bei Vorliegen des Fahrzeugtyps F3 für das Signals S2 der dem Steckkontakt zugeordnete Treiber T4 als Sende-Einheit umkonfiguriert.

Da die Konfigurierung der Treiber, die den Steckkontakten 1 bis 6 der Universalsteckerverbindung DS zugeordnet sind, in Abhängigkeit vom momentan vorliegenden Kraftfahrzeugtyp F1 bis F3 vorgenommen wird, wird der Adaptereinheit AD, insbesondere dem Baustein FPGA eine Information über den gerade vorliegenden Kraftfahrzeugtyp übermittelt. Hierzu erhält der Baustein FPGA beispielsweise ein eigenes Eingangssignal, das durch die manuelle Betätigung eines Bedienfeldes B an der zentralen Rechnereinheit R erzeugt wird. Der Baustein FPGA kann jedoch auch zu Beginn der Inbetriebnahme des Diagnoseprüfgeräts automatisch durch das Anliegen der Art der Signale an den Steckkontakten 1 bis 6 der Universalsteckerverbindung DS erkennen, welcher Fahrzeugtyp F1 bis F3 gerade angeschlossen ist.

Die Adaptereinheit AD kann jedoch auch eine Anpassung elektrischer Eigenschaften der zu übertragenden Signale vornehmen. Beispielsweise könnten die Signale S1 der Fahrzeugtypen F1 und F2, zwar auf demselben Steckkontakt 3 der Universalsteckerverbindung DS übertragen werden, sie könnten auch in ihrem Informationsgehalt gleichartig sein, sich jedoch in ihren Ausgangspegeln unterscheiden. Beispielsweise könnte das Signal S1 des Fahrzeugtyps F1 einen Wechsel zwischen 0 V und 12 V-Pegeln vornehmen, wogegen das Signal S1 des Fahrzeugtyps F2 einen Wechsel zwischen 0 V und 5 V-Pegeln vornehmen könnte. In diesem Fall wird der dem Steckkontakt 3 zugeordnete Treiber T2, beispielsweise mittels eines Spannungsumschalters E2 eine Anpassung der Pegel, die in diesem Fall elektrische Eigenschaft des zu übertragenden Signals S1 sind, vornehmen. Beispielsweise sind den Treibern T1 und T4 ebenfalls Spannungsumschalter E1 und E3 zugeordnet, die bei Bedarf für eine Pegelanpassung einsetzbar sind. Im vorliegenden Ausführungsbeispiel weisen lediglich die Treiber T1, T2 und T4 derartige Spannungsumschalter E1, E2 und E3 auf, da beispielsweise nur an den diesen Treibern zugeordneten Steckkontakten 2, 3 und 5 für sämtliche unterschiedliche Kraftfahrzeugtypen Signale möglich sind, für die eine Pegelanpassung notwendig sein könnte.

Elektrische Eigenschaften zu übertragender Signale sind beispielsweise auch Eingangsschaltschwellen. Schaltschwellen zur Definition eines high- oder low-Pegels können beispielsweise für das Eingangssignal S2 der Fahrzeugtypen F1 bis F3 unterschiedlich definiert sein. Zur Anpassung derartiger Eingangsschwellen können Schwellenumschalter SU1 und SU2 mit Treibern, z. B. T3 und T4, zusammenwirken. Schwellenumschalter sind jedoch auch nur für die Treiber notwendig, die Steckkontakten der Universalsteckerverbindung zugeordnet sind, über die Signale zum Fahrzeug übertragen werden und für die unterschiedliche Eingangsschaltschwellen definiert sind.

Auch können unterschiedliche Innenwiderstände (pull-up, pull-down) an den Ein- oder Ausgängen der Steuergeräte SG als elektrische Eigenschaften bzw. als die eine elektrische Eigenschaft der zu übertragenden Signale beeinflussende Größen mittels der Treiber und des Bausteins FPGA berücksichtigt werden. Unterschiedliche Innenwiderstände, unterschiedliche Eingangsschaltschwellen und unterschiedliche Ausgangspegel sind jedoch nur Beispiele für mögliche elektrische Eigenschaften der zu übertragenden Signale.

Erfindungswesentlich ist bezogen auf das Ausführungsbeispiel die Möglichkeit, den bestimmten Signalen, hier S1 bis S4, zugeordneten Anschlüsse des Diagnoseprüfgeräts bzw. der zentralen Rechnereinheit R unabhängig von der kraftfahrzeugseitigen Zuordnung dieser Signale S1 bis S4 zu den Steckkontakten 1 bis 6 der Universalsteckerverbindung DS, d. h. unabhängig von der Signalbelegung der Steckkontakte, die entsprechenden Signale S1 bis S4 zuzuführen. Die hierfür erforderlichen elektrischen Verbindungen werden durch die Adaptereinheit AD vorgenommen, insbesondere durch den in seiner Funktion und/oder in seiner Pinbelegung umprogrammierbaren Baustein FPGA. Während der Baustein FPGA für die Logik im Hinblick auf die unterschiedlichen Signalbelegungen der Steckkontakte im wesentlichen zuständig ist, werden mittels der konfigurierbaren Treiber Probleme ausgeräumt, die durch unterschiedliche elektrische Eigenschaften der zu übertragenden Signale der den unterschiedlichen Fahrzeugtypen zugeordneten Steuergeräte entstehen. Ergänzend wird darauf hingewiesen, daß die Schwellenumschalter SU1 und SU2, die Spannungsumschalter E1 bis E3 und ggf. weitere elektrische Eigenschaften beeinflussenden Bauelemente auch in den Treibern integriert sein können, zumindest aber mit den Treibern eine funktionelle Einheit bilden.

Ergänzend wird darauf hingewiesen, daß zur entsprechenden Konfigurierung der Treiber diese eine entsprechende elektrischen Ausstattung aufweisen müssen. Es müssen jedoch nicht alle Treiber gleich ausgestattet sein. Wird ein Treiber beispielsweise von allen in Frage kommenden Fahrzeugtypen nur als Sender-Einheit benötigt, ist keine Ausstattung erforderlich, die auch eine Empfänger-Einheit ermöglichen würde.

Durch das Ausführungsbeispiel wird deutlich, daß durch die Erfindung lediglich eine einzige Universalsteckerverbindung für sämtliche Kraftfahrzeugtypen einsetzbar ist. Darüber hinaus wird durch die automatische Adaptereinheit AD die Bedienerfreundlichkeit eines Diagnoseprüfgeräts deutlich erhöht.

## Patentansprüche

1. Diagnoseprüfgerät für elektronische Steuergeräte (SG) in unterschiedlichen Kraftfahrzeugtypen (F1, F2, F3), das über eine Steckerverbindung an einen mit den zu diagnostizierenden Steuergeräten (SG) verbundenen Diagnosesteckeranschluß in jedem Kraftfahrzeug anschließbar ist, der mit einer vorgegebenen Anzahl von Steckkontakten (1 bis 6) mechanisch, nicht aber bezogen auf die Signalbelegung der Steckkontakte (1 bis 6) und auf die elektrischen Eigenschaften der zu übertragenden Signale (S1, S2, S3, S4) normiert ist, dadurch gekennzeichnet, daß die Steckerverbindung eine für die unterschiedlichen Kraftfahrzeugtypen (F1, F2, F3) identische Universalsteckerverbindung (DS) ist, die an den normierten Diagnosesteckeranschluß mechanisch angepaßt ist, und daß am diagnosegerätseitigen Ende der Universalsteckerverbindung (DS) eine Adaptereinheit (AD) angeschlossen ist, die automatisch die erforderlichen elektrischen Verbindungen zwischen den Steckkontakten (1 bis 6) der Universalsteckerverbindung (DS) und der zentralen Rechnereinheit (R) des Diagnosegeräts entsprechend der jedem Kraftfahrzeugtyp zuordneten Signalbelegung der Steckkontakte (1 bis 6) herstellt.

2. Diagnoseprüfgerät nach Patentanspruch 1, dadurch gekennzeichnet, daß durch die Adaptereinheit (AD) die elektrischen Eigenschaften der zwischen der zentralen Recheneinheit (R) und dem Diagnosesteckeranschluß zu übertragenden Signale (S1, S2, S3, S4) in Abhängigkeit vom Kraftfahrzeugtyp (F1, F2, F3) umschaltbar sind.

3. Diagnoseprüfgerät nach Patentanspruch 1 oder 2, dadurch gekennzeichnet, daß die Adaptereinheit (AD) einen in seiner Funktion und/oder in seiner Pinbelegung umprogrammierbaren Baustein (FPGA) sowie jedem Steckkontakt (1 bis 6) zugeordnete Treiber in Form von universellen Sender- und/oder Empfänger-Einheiten enthält, wobei die Treiber einerseits direkt an die Universalsteckerverbindung (DS) anschließbar sind und andererseits mittels des umprogrammierbaren Bausteins (FPGA) zur Herstellung der erforderlichen elektrischen Verbindungen entsprechend der jedem Kraftfahrzeug zuordneten Signalbelegung der Steckkontakte und/oder zur Umschaltung der elektrischen Eigenschaften der zu übertragenden Signale (S1, S2, S3, S4) konfigurierbar sind.
